# EUROPÄISCHE PATENTSCHRIFT

(11) **EP 1 151 472 B1**
(45) Veröffentlichungstag und Bekanntmachung des Hinweises auf die Patenterteilung: **02.07.2003**
(21) Anmeldenummer: 99962225.1
(22) Anmeldetag: 06.12.1999
(51) Int. Cl.: H01L 21/98, H01L 25/065

(54) **VERFAHREN ZUR VERTIKALEN INTEGRATION VON AKTIVEN SCHALTUNGSEBENEN**
METHOD FOR VERTICALLY INTEGRATING ACTIVE CIRCUIT PLANES
PROCEDE POUR L'INTEGRATION VERTICALE DE PLANS DE CIRCUIT ACTIFS

(30) Priorität: 08.12.1998 DE 19856573
(43) Veröffentlichungstag der Anmeldung: 07.11.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: FEIL, Michael, D-81475 München (DE); LANDESBERGER, Christof, D-81241 München (DE)
(74) Vertreter: Schoppe, Fritz, Dipl.-Ing.
(86) Internationale Anmeldenummer: EP9909540
(87) Internationale Veröffentlichungsnummer: WO00035007

(56) Entgegenhaltungen:
- EP-A- 0 890 989
- WO-A-92/09098
- WO-A-95/09438
- DE-C- 19 516 487
- US-A- 5 266 511
- US-A- 5 656 553

## Beschreibung

Die vorliegende Erfindung bezieht sich auf Verfahren zur vertikalen Integration von zwei aktiven Schaltungsebenen.

In einem Substrat angeordnete integrierte Schaltungen befinden sich im wesentlichen in der Nähe einer Hauptoberfläche des Substrats. So spielt sich bei integrierten Schaltungen das aktive Leben der Transistoren nur in der obersten Ebene des Substrats, beispielsweise des Siliziumkristalls, in einem Dickenbereich von weniger als 2 µm ab. Das restliche, einige 100 µm dicke Silizium des Substrats wird für die Schaltungsfunktion nicht benötigt. Es existieren daher seit einiger zeit verstärkt Anstrengungen, die dritte Dimension, d.h. die Dickendimension, besser zu nutzen.

Die Herstellung einer integrierten Schaltung beispielsweise in CMOS-Technologie beinhaltet in der Regel weit über 100 einzelne Prozeßschritte, von denen jeder für sich mit einer Ausbeute von annähernd 100% beherrscht werden muß, um zu einer vernünftigen Ausbeute zu gelangen. Versuche, weitere Schaltungsebenen durch Weiterprozessierung auf vorhandenen Ebenen aufzubauen, um dadurch eine weitere Schaltungsebene direkt zu integrieren, würde die Verdoppelung der Prozeßschritte bedeuten, wodurch die Anforderungen an die Ausbeute exponentiell steigen würden. Somit ist eine derartige Ausnutzung der Dickendimension praktisch nicht sinnvoll realisierbar.

Hingegen bedeutet die Verbindung zweier unabhängig voneinander prozessierter Wafer für den einzelnen Wafer nur eine geringe Zahl von zusätzlichen Schritten. Neuere Lösungen basieren daher auf der Stapelung von fertig prozessierten Chips, wobei die Kontakte an einer Seite herausgeführt und miteinander verdrahtet werden. Derartige Techniken sind beispielsweise bei M.F. Suer, u.a.: "High Density 3D Packaging", Proc. VLSI Packaging Workshop (1991), und C.L. Bertin, u.a.: "Evaluation of a Three-Dimensional Memory Cube System", IEEE Transactions on Components, Hybrids and Manufactoring Technology, Bd. 16(8), S. 1006 (1993), offenbart. Diese Verfahren eignen sich jedoch nur für Bausteine mit wenigen Anschlüssen, beispielsweise für Speicherbausteine, nicht jedoch für Logikbauelemente mit einer Vielzahl von Anschlüssen.

Andere Konzepte beruhen auf der Basis dreidimensionaler Multichipmodul-Techniken (3D-MCM-Techniken). Dabei werden mehrere Multichipmodule aufeinander gestapelt. Dies geschieht in der Form, daß ein oder mehrere Chips auf einem Träger montiert werden, um zusammen ein Multichipmodul zu bilden, woraufhin dann mehrere Träger miteinander verbunden und verdrahtet werden. Derartige Techniken sind beispielsweise bei H. Nakanishi, u.a.: "Development of High Density Memory IC Package by Stacking IC Chips", Proc. IEEE Electronic Components and Technology Conference, S. 634 (1995); C.G. Massit, G.C. Nicolas: "High Performance 3D MCM Using Microtechnologies", Proc. IEEE Electronic Components and Technology Conference, S. 641 (1995); J. Barret, u.a.: "Performance and Reliability of a Three-Dimensional Plastic Moulded Vertical Multichip Module (MCM-V)", Proc. IEEE Electronic Components and Technology Conference, S. 656 (1995); sowie in der US-5202754 beschrieben.

Aus der DE 4433846 A, der DE 4433845 A, der DE 4433833 A und dem US-Patent 5563084 sind ferner Verfahren zur vertikalen Integration beschrieben, die auf einem sogenannten Interchip-Via-Konzept (ICV-Konzept) beruhen. Bei diesem Konzept werden zunächst Wafer standardmäßig prozessiert. Zwei Wafer werden dann verbunden, wobei zum Stapeln der oberen Wafer auf eine Dicke von ca. 10 µm gedünnt und nachfolgend auf den unteren Wafer geklebt wird. Anschließend werden mit einem aus der Halbleitertechnik üblichen, aber abgewandelten Grabenherstellungsverfahren (Trenchherstellungsverfahren) die elektrischen Verbindungen zwischen oberer und unterer Ebene hergestellt. Bei dem ICV-Konzept ist die aktive Seite des Wafers jeweils oben angeordnet, so daß zwar prinzipiell das Stapeln mehrerer Ebenen möglich ist, wobei die Kontakte von einer Ebene zur anderen jedoch durch den Wafer hindurchgeführt werden müssen. Zu dieser Kontaktdurchführung sind Prozesse nötig, die Temperaturen oberhalb von 400°C benötigen. Nachteilig an dem ICV-Konzept ist ferner, daß zum Dünnen des oberen Wafers Hilfsträger und somit entsprechend aufwendige Umbondprozesse notwendig sind.

Die DE 44 27 515 C1 beschreibt ein Verfahren zur Herstellung einer dreidimensionalen Schaltungsanordnung, bei dem eine Substratscheibe, die in einer ersten Hauptoberfläche Bauelemente umfaßt, auf eine Trägerplatte aufgeklebt, daraufhin gedünnt und nach Aufbringen einer Photolackmaske und unter Verwendung derselben als Ätzmaske durch einen Ätzprozeß vereinzelt wird, so daß das Splittern der gedünnten Substratscheiben vermieden und eine bessere Materialausnutzung erzielt wird.

Die DE 42 38 137 A1 beschreibt ein Verfahren zur Herstellung von Vorrichtungen mit Bauelementen, die aus unterschiedlichen Materialien hergestellt sind.

Aus der DE 195 16 487 C1 ist ein Verfahren zur vertikalen Integration mikroelektronischer Systeme bekannt, bei dem zwei Substrate Vorderseite an Vorderseite verbunden werden. Als Vorderseite wird dabei die Seite des Substrats bezeichnet, auf der Schaltungslagen und zugeordnete Metallisierungen gebildet sind. Ein erstes Substrat wird vorbereitet, indem von der Vorderseite desselben her ein Vialoch in demselben gebildet wird, das zumindest die Schaltungslagen vollständig durchdringt und durch eine Metallisierung auf der Vorderseite des ersten Substrats verläuft. Anschließend wird die Vorderseite des ersten Substrats mit der Vorderseite eines zweiten Substrats verbunden, wobei die Metallisierung auf der Vorderseite des ersten Substrats mit einer Metallisierung auf der Vorderseite des zweiten Substrats ausgerichtet ist. Nach dem Verbinden sind die ausgerichteten Metallisierungen auf dem ersten und dem zweiten Substrat nicht elektrisch leitend miteinander verbunden. Diese elektrisch leitfähige Verbindung wird erreicht, indem das erste Substrat soweit gedünnt wird, daß das Vialoch von der Rückseite her freiliegt, woraufhin isolierende Schichten über der Metallisierung des zweiten Substrats durch das Vialoch entfernt werden, so daß durch ein Füllen des Vialochs mit einem leitfähigen Material die Metallisierungen auf dem ersten Substrat und dem zweiten Substrat elektrisch leitend verbunden werden.

Die Aufgabe der vorliegenden Erfindung besteht darin, ein Verfahren zur vertikalen Integration von aktiven Schaltungsebenen zu schaffen, das eine erhebliche Vereinfachung der Prozeßfübrung ermöglicht.

Diese Aufgabe wird durch ein Verfahren gemäß Anspruch 1 gelöst.

Die vorliegende Erfindung schafft ein Verfahren zur vertikalen Integration von aktiven Schaltungsebenen, bei dem zunächst ein erstes Substrat mit zumindest einer integrierten Schaltung in einer ersten Hauptoberfläche desselben und mit Anschlußflächen für die integrierte Schaltung und mit Außenanschlußflächen auf der ersten Hauptoberfläche desselben bereitgestellt wird. Überdies wird ein zweites Substrat mit zumindest einer integrierten Schaltung in einer ersten Hauptoberfläche desselben und mit Anschlußflächen für die integrierte Schaltung und mit ausgesparten oder aussparbaren Bereichen auf der ersten Hauptoberfläche desselben bereitgestellt. Die erste Hauptoberfläche des ersten und des zweiten Substrats werden derart verbunden, daß die Anschlußflächen des ersten Substrats mit denen des zweiten Substrats elektrisch leitfähig verbunden sind, und derart, daß die Außenanschlußflächen des ersten Substrats mit den ausgesparten oder aussparbaren Bereichen des zweiten Substrats ausgerichtet sind. Anschließend wird das zweite Substrat gedünnt, und die Außenanschlußflächen werden durch die ausgesparten oder aussparbaren Bereiche freigelegt.

Vorzugsweise sind gemäß der vorliegenden Erfindung das erste und das zweite Substrat ein erster und ein zweiter Wafer, die jeweils eine Mehrzahl integrierter Schaltungen in der ersten Hauptoberfläche derselben und diesen integrierten Schaltungen jeweils zugeordnete Anschlußflächen auf der ersten Hauptoberfläche derselben aufweisen. Auf der ersten Hauptoberfläche des ersten Substrats bzw. des ersten Wafers können Außenanschlußflächen vorgesehen sein, die nach dem Verbinden des ersten und des zweiten Substrats, bzw. des ersten und des zweiten Wafers, in einer solchen Beziehung zu ausgesparten Bereichen in dem zweiten Substrat, bzw. dem zweiten Wafer, angeordnet sind, daß sie durch die ausgesparten Bereiche in dem zweiten Substrat, bzw. dem zweiten Wafer, zugänglich sind. Somit kann nach dem Zurückdünnen des zweiten Substrats eine externe Kontaktierung von äußeren Anschlüssen der in dem ersten Substrat bzw. Wafer angeordneten integrierten Schaltung erreicht werden.

Handelt es sich bei dem ersten und dem zweiten Substrat um einen ersten und einen zweiten Wafer, wird nach dem Durchführen des erfindungsgemäßen Verfahrens eine Vereinzelung durchgeführt, um die erzeugte Mehrschichtstruktur zu einer Mehrzahl von vertikal integrierten Schaltungen bzw. Mehrchipmodulen, die jeweils aus zwei miteinander verbundenen integrierten Schaltungen gebildet sind, zu vereinzeln.

Gemäß der vorliegenden Erfindung werden bzw. sind die Hauptoberflächen des ersten und zweiten Substrats miteinander verbunden, in denen die integrierten Schaltungen gebildet sind. Dadurch sind lediglich extrem kurze Verbindungen von einer Schaltungsebene zur anderen notwendig, was höhere Systemgeschwindigkeiten ermöglicht und ferner die Minimierung der Verlustleistung unterstützt. Erfindungsgemäß werden die einzelnen Schaltungsebenen vorzugsweise als Wafer unabhängig voneinander prozessiert und erst gegen Ende des Herstellungsablaufs miteinander verbunden. Dadurch erfordert die Verbindung der zwei unabhängig voneinander prozessierten Wafer für den einzelnen Wafer nur eine geringe Zahl von zusätzlichen Schritten. Somit ist erfindungsgemäß eine hohe Ausbeute möglich. Überdies können die einzelnen Ebenen in unterschiedlichen Technologien hergestellt werden, beispielsweise CMOS-Bipolar, Hochspannungs-Standard-CMOS, Niederspannungs-Standard-CMOS oder SOI-Standard-CMOS (SOI = Silicon On Insulator). Somit sind keine hochkomplexen Universaltechnologien notwendig.

Die Nutzung der dritten Dimension bei integrierten Schaltkreisen eröffnet vielfältige Anwendungsgebiete. Die Integrationsdichte kann gesteigert und somit Platz eingespart werden. Konkrete Anwendungsgebiete sind die Hardware-Realisierung von Codierungs-, Kompressions- und Datenreduktions-Verfahren in der Telekommunikation oder von Verfahren der Bildverarbeitung in Echtzeit. Insbesondere eignet sich die Erfindung für tragbare Systeme, beispielsweise Handys oder Sicherheitssysteme unter Verwendung der sogenannten Krypto-Technik. Bei den Letztgenannten werden einzelne Schaltungselemente auf die verschiedenen Ebenen verteilt, so daß nach einem nachträglichen Öffnen der Schaltungsebenen die Schaltungsfunktion nicht mehr erkennbar ist. Es ist somit klar, daß die vorliegende Erfindung in einer Vielzahl von Bereichen vorteilhaft einsetzbar ist.

Bevorzugte Ausführungsbeispiele der vorliegenden Erfindung werden nachfolgend bezugnehmend auf die beiliegenden Zeichnungen, in denen jeweils gleiche Elemente mit gleichen Bezugszeichen bezeichnet sind, näher erläutert. Es zeigen:
- Fig. 1a) und 1b): schematische Querschnittansichten eines ersten und eines zweiten Substrats, die bei dem erfindungsgemäßen Verfahren verwendet werden;
- Fig. 2a) und 2b): schematische Draufsichten des ersten und des zweiten Substrats der Fig. 1a) und 1b);
- Fig. 3a) bis 3c): schematische Querschnittansichten zur Veranschaulichung der Herstellungsschritte eines Ausführungsbeispiels des erfindungsgemäßen Verfahrens;
- Fig. 4: eine schematische Draufsicht eines alternativen Ausführungsbeispiel eines bei dem erfindungsgemäßen Verfahren zu verwendenden Substrats; und
- Fig. 5: eine schematische Draufsicht eines weiteren alternativen Ausführungsbeispiels eines bei dem erfindungsgemäßen Verfahren zu verwendenden Substrats.

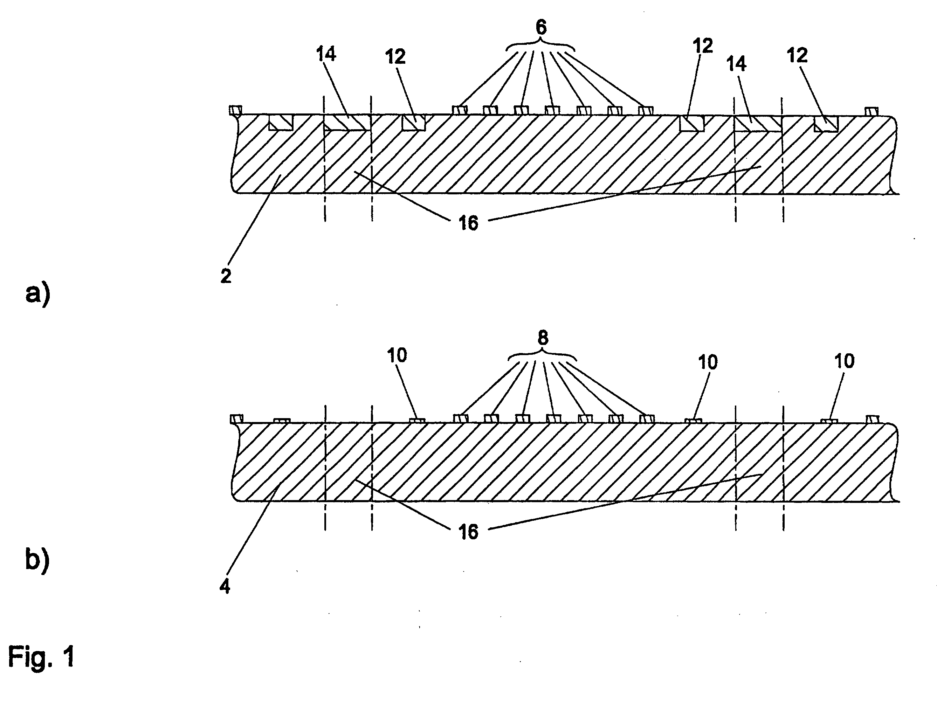

Gemäß bevorzugten Ausführungsbeispielen der vorliegenden Erfindung werden zwei Wafer in gleichen oder unterschiedlichen Standard-Herstellungsverfahren fertiggestellt. In den Fig. 1a) und 1b) sind schematische Querschnittansichten von zwei solchen Wafern gezeigt, wobei der in Fig. 1a) gezeigte Wafer 2 im folgenden als oberer Wafer bezeichnet wird, während der in Fig. 1b) gezeigte Wafer 4 im folgenden als unterer Wafer bezeichnet wird.

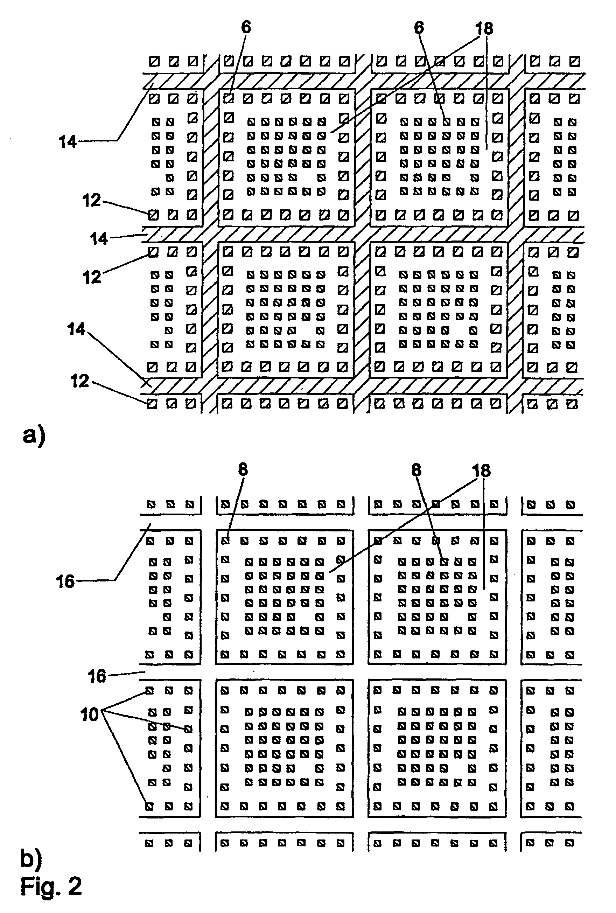

Der obere Wafer 2 besitzt eine Mehrzahl von Anschlußflächen 6, die im folgenden als innere Anschlußflächen bezeichnet werden, da dieselben zur direkten Verbindung mit inneren Anschlußflächen 8 des unteren Wafers 4 dienen sollen. Die Anschlußflächen 6 und 8 sind jeweils oberhalb von in den Wafern 2 und 4 gebildeten integrierten Schaltungen (nicht dargestellt) angeordnet. Die integrierten Schaltungen befinden sich quasi in der oberen Hauptoberfläche der beiden Wafer, d.h. beispielsweise in einem Dickenbereich von weniger als 2 µm unterhalb der oberen Hauptoberfläche. Der untere Wafer 4 besitzt ferner Außenanschlußflächen 10, die auf der oberen Oberfläche desselben angeordnet sind, wie auch in der Draufsicht von Fig. 2b) zu sehen ist. Dagegen weist der obere Wafer 2 in dem Bereich, in dem der untere Wafer 4 die Außenanschlußflächen 10 besitzt, Aussparungen 12 auf, die bei dem dargestellten Ausführungsbeispiel mit einem Polymer gefüllt sind. Ferner besitzt der obere Wafer Ausnehmungen 14, die in dem Bereich späterer Sägestraßen 16 zum Vereinzeln von Mehrschichtmodulen gebildet sind. Die Ausnehmungen 14 sind bei dem dargestellten Ausführungsbeispiel ebenfalls mit einem Polymer gefüllt. Durch die Aussparungen 14 sind in dem oberen Wafer 2 bereits die einzelnen Chips 18 definiert. Auch in der Draufsicht von Fig. 2b) sind bereits die späteren Sägestraßen 16 schematisch eingezeichnet, so daß auch hier die Struktur der einzelnen Chips 18 zu erkennen ist.

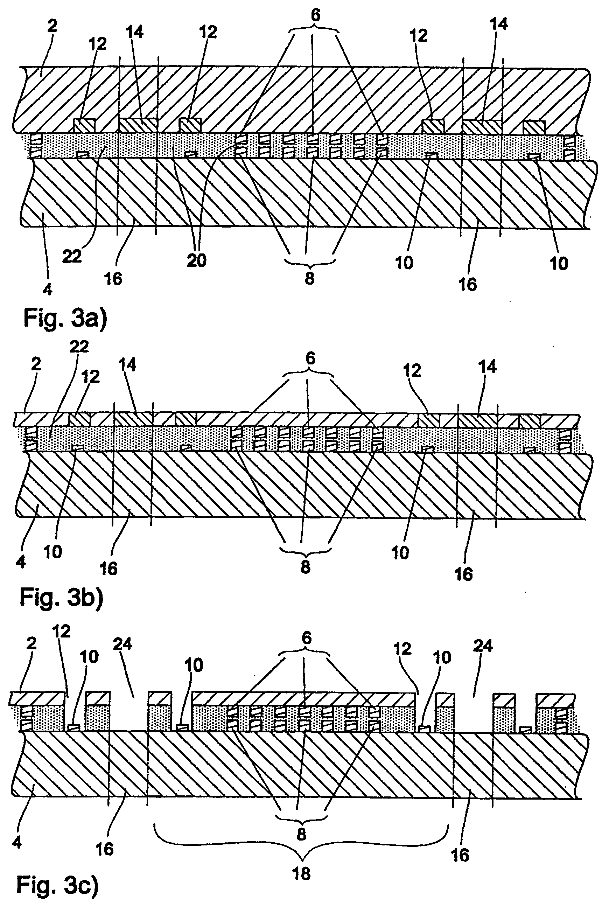

Die Aussparungen 12 und 14 werden beispielsweise mittels herkömmlicher Tiefenätzverfahren in der oberen Oberfläche des oberen Wafers 2 gebildet. Die Tiefe der Ätzungen entspricht dabei etwa der späteren Dicke des oberen Wafers 2, nachdem derselbe einer Dünnung unterworfen wurde, wie nachfolgend bezugnehmend auf Fig. 3b) näher erläutert wird. In diese Ätzungen wird dann vorzugsweise ein Polymer eingebracht, wie oben erläutert wurde.

Wie insbesondere den Draufsichten von Fig. 2a) und 2b) zu entnehmen ist, besitzen die einzelnen Chips 18, die noch im Waferverbund vorliegen, eine identische flächenmäßige Ausdehnung sowie spiegelbildlich zueinander passende innere Anschlußflächen 6 und 8, deren Lage auf der Chipfläche frei wählbar ist. Über diese inneren Anschlußflächen 6 und 8 werden später die elektrischen Verbindungen zwischen den beiden Ebenen, die durch den oberen und den unteren Wafer gebildet sind, hergestellt. Der obere und der untere Wafer, die in den Fig. 1a) und 1b) dargestellt sind, werden dann erfindungsgemäß zusammengefügt, um eine Mehrschichtstruktur zu bilden.

Die beiden Wafer 2 und 4 nach dem Zusammenfügen derselben sind in Fig. 3a) dargestellt. Dazu werden die Wafer 2 und 4 derart zueinander justiert, daß die jeweiligen Oberflächen derselben, auf denen die inneren Anschlußflächen 6 bzw. 8 gebildet sind, einander gegenüberliegen. Wie in Fig. 3a) zu sehen ist, sind dabei die inneren Anschlußflächen 6 des oberen Wafers 2 mit den inneren Anschlußflächen 8 des unteren Wafers 4 ausgerichtet. In dieser Lage werden die beiden Wafer mechanisch und elektrisch miteinander verbunden, wodurch die inneren Anschlußflächen 6 des oberen Wafers 2 mit den inneren Anschlußflächen 8 des unteren Wafers 4 elektrisch leitfähig verbunden werden.

Zum gleichzeitigen mechanischen und elektrischen Verbinden der beiden Wafer ist eine Vielzahl, meist aus der Flip-Chip-Technik bekannter Verfahren einsetzbar, beispielsweise ein Thermokompressionsbonden, ein Legieren, ein Löten oder ein Kleben. Eine bevorzugte Form ist hierbei die Verwendung eines Klebers, da hierdurch eine ganzflächige Verbindung erzeugt wird. Im Gegensatz dazu muß bei den anderen Verfahren noch der Spalt mit einem sogenannten Unterfüller (Underfiller) gefüllt werden. Beim Kleben kann wiederum zwischen zwei Varianten unterschieden werden. Zum einen kann ein nichtleitender Kleber verwendet werden, wobei dann der elektrische Kontakt zwischen den inneren Anschlußflächen 6 und 8 mittels eines durch die Klebermatrix gehaltenen direkten Kontakts der Anschlußflächen erzeugt wird.

Bei dem in den Fig. 3a) bis 3c) dargestellten Ausführungsbeispiel des erfindungsgemäßen Verfahrens ist jedoch ein anisotrop leitfähiger Kleber 22 verwendet, bei dem der elektrische Kontakt zwischen zwei gegenüberliegenden Anschlußflächen 6 und 8 über kleine leitfähige Kugeln 20, die in dem Kleber angeordnet sind, hergestellt wird. Es ist vorteilhaft, beim Zusammenkleben der Wafer darauf zu achten, daß die Klebefuge möglichst gleichmäßig und dünn ist, was eine weitgehende Reduzierung der Bumphöhe der Anschlußflächen bedeutet. Nach dem Zusammenkleben der beiden Wafer 2 und 4 ergibt sich die in Fig. 3a) dargestellte Struktur.

Ausgehend von dieser Struktur wird bei dem dargestellten Ausführungsbeispiel der obere Wafer 2 von der Hauptoberfläche desselben her, die der Hauptoberfläche, auf der die Anschlußflächen 6 angeordnet sind, gegenüberliegt, gedünnt. Der obere Wafer kann beispielsweise auf eine Restdicke von ≤50 µm gedünnt werden. Wie oben bereits erläutert wurde, weisen die Aussparungen 12 und 14 in dem oberen Wafer 2 vorzugsweise eine Tiefe auf, die der Dicke des oberen Wafers 2 nach der Dünnung desselben entspricht. Dadurch ergibt sich nach dem Dünnen die in Fig. 3b) dargestellte Struktur, bei der die mit Polymer gefüllten Aussparungen 12 und 14 den oberen Wafer 2 vollständig durchdringen. Die in diesem Verfahrensstadium mit Polymer gefüllten Aussparungen 12 und 14 sind erforderlich, damit die Lage der einzelnen Chips 18, Fig. 2a) und 2b), erkennbar bleiben und ferner später eine Zugänglichkeit zu den Außenanschlußflächen 10 auf dem unteren Wafer 4 realisiert werden kann.

Das Füllen der Aussparungen 12 und 14 erleichtert das Dünnen des oberen Wafers 2. Wie bereits dargelegt wurde, können je nach vorgesehener Restdicke des oberen Wafers 2 und je nach Verbindungsprozeß für die Wafer die Aussparungen im oberen Wafer mit einem Polymer so aufgefüllt werden, daß sie plan mit der Oberfläche abschließen, wobei alternativ der als Verbindungselement vorgesehene Kleber 22 gleichzeitig zum Auffüllen der Aussparungen verwendet werden kann.

Nach dem somit erfolgten Dünnen des oberen Wafers 2 wird bei dem bevorzugten Ausführungsbeispiel des erfindungsgemäßen Verfahrens die Polymerfüllung aus den Aussparungen 12 und 14 entfernt und ferner der unter diesen Polymerfüllungen der Aussparungen 12 und 14 angeordnete Kleber beseitigt. Durch diese Schritte ergibt sich die in Fig. 3c) dargestellte Struktur. Wie zu erkennen ist, sind die Außenanschlußflächen 10 des unteren Wafers 4 durch die nunmehr offenen Ausnehmungen 12 in dem oberen Wafer 2 zugänglich. Bei dem obigen Verfahren des Entfernens des Polymers aus den Aussparungen 12 und des Beseitigens des darunter liegenden Klebers können gleichzeitig das Polymer aus den Aussparungen 14 sowie der darunter liegende Kleber beseitigt werden, so daß sich die in Fig. 3c) dargestellten Öffnungen 24 ergeben. Entlang dieser sich ergebenden Öffnungen 24 erfolgt nachfolgend die Vereinzelung, um einzelne Chipmodule herzustellen. Der in Fig. 3c) dargestellte Aufbau kann wie ein herkömmlicher Standardwafer weiterverarbeitet werden, d.h. beispielsweise einer Vereinzelung mittels geeigneter Diamantsägen und dergleichen zugeführt werden. Alternativ zu dem dargestellten Ausführungsbeispiel kann auch der untere Wafer 4 einer Dünnung unterzogen werden, wenn ein insgesamt sehr dünnes Modul hergestellt werden soll. Das Dünnen des oberen und unteren Wafers 2 und 4 kann mittels herkömmlicher Techniken, beispielsweise Schleifen, Ätzen, Polieren und dergleichen durchgeführt werden.

Nach dem Vereinzeln entlang der Sägestraßen 16 liegen dann die erfindungsgemäßen Chipmodule 18 vor, die aus zwei in unterschiedlichen Substraten angeordneten integrierten Schaltungen bestehen. Dabei sind die beiden Substrate derart miteinander verbunden, daß die Oberflächen derselben, in denen jeweils die integrierte Schaltung gebildet ist, einander zugewandt sind. Ferner ist durch die direkte Verbindung der Anschlußflächen der jeweiligen integrierten Schaltungen sehr kurze Verbindungswege realisierbar.

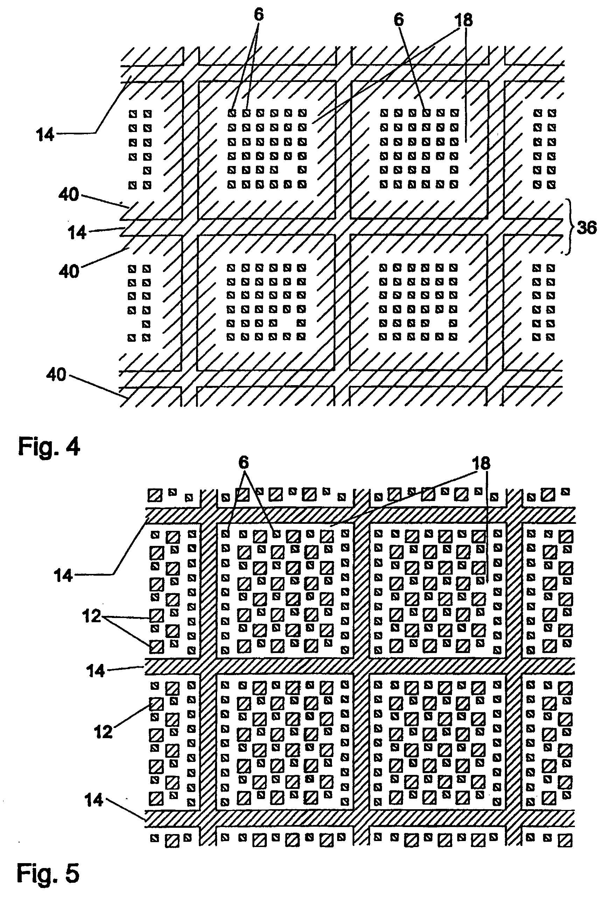

In Fig. 4 ist eine schematische Draufsicht eines alternativen Ausführungsbeispiels des oberen Wafers dargestellt. Im Unterschied zu dem oben beschriebenen Ausführungsbeispiel sind bei dem in Fig. 4 dargestellten Ausführungsbeispiel keine individuell hergestellten Aussparungen 12 für die Außenanschlußflächen 10 des unteren Wafers vorgesehen, sondern vielmehr ist ein breiter Rahmen 36, bestehend aus Sägestraßen 14 und Aussparungen 40 für Außenanschlußflächen 10 entlang der einzelnen Chips 18 vorgesehen. Diese Anordnung erfordert in jedem Fall, daß die Außenanschlußflächen 10 auf dem unteren Wafer 4 entlang des Rands der einzelnen Chips angeordnet sind. Eine alternative Anordnung der Innenanschlußflächen 6 und der Aussparungen 12 für die Außenanschlußflächen auf dem zweiten Wafer ist in Fig. 5 dargestellt. Dabei sind die Innenanschlußflächen 6 und die Aussparungen 12 jeweils im wesentlichen abwechselnd innerhalb der jeweiligen Chips 18 angeordnet. Es ist jedoch offensichtlich, daß beliebige Anordnungen von Innenanschlußflächen und Aussparungen für die Außenanschlußflächen auf dem ersten Wafer möglich sind, solange jeweils eine spiegelbildliche Entsprechung der Aussparungen 12 und der Außenanschlußflächen 10 auf dem unteren Wafer 4 geliefert wird.

Die vorliegende Erfindung liefert eine Vielzahl von Vorteilen. Durch die Schichtstruktur sind sehr hohe Integrationsdichten erzielbar, wobei dennoch ein extrem dünner Gesamtaufbau möglich ist. Durch die äußerst kurzen Verbindungen zwischen den Schaltungsebenen sind überdies Schaltungsmodule, die bei sehr hohen Frequenzen und mit einer sehr geringen Treiberleistung betreibbar sind, realisierbar. Überdies sind weitgehendst lediglich Standardprozesse zum Durchführen der erfindungsgemäßen Verfahren notwendig. Zum Dünnen des oder der Wafer sind keine Hilfsträger notwendig. Schließlich sind keine Hochtemperaturschritte nötig, um die Wafer zu verbinden. Somit liefert die vorliegende Erfindung ein äußerst wirtschaftliches Verfahren zur Herstellung höchstintegrierter Schaltungen und aufgrund eines geringen Ausschusses und des einfachen Herstellungsverfahrens kostengünstige Mehrchipmodule.

Die gemäß der vorliegenden Erfindung hergestellten Chips können mit standardmäßigen Verfahren weiterverarbeitet werden.

## Patentansprüche

1. Verfahren zur vertikalen Integration von aktiven Schaltungsebenen zur Erzeugung eines Mehrschichtmoduls, bei dem integrierte Schaltungen über innere Anschlußflächen elektrisch leitfähig verbunden sind und das externe Anschlüsse aufweist, mit folgenden Schritten:
Bereitstellen eines ersten Substrats (4) mit zumindest einer integrierten Schaltung in einer ersten Hauptoberfläche desselben und mit inneren Anschlußflächen (8) für die integrierte Schaltung und mit Außenanschlußflächen (10) auf der ersten Hauptoberfläche desselben;
Bereitstellen eines zweiten Substrat (2) mit zumindest einer integrierten Schaltung in einer ersten Hauptoberfläche desselben, mit inneren Anschlußflächen (6) für die integrierte Schaltung und mit ausgesparten oder aussparbaren Bereichen (12; 40) in der ersten Hauptoberfläche desselben;
mechanisches Verbinden der ersten Hauptoberflächen des ersten und des zweiten Substrats (4, 2) und dadurch gleichzeitig elektrisch leitfähiges Verbinden der inneren Anschlußflächen (8) des ersten Substrats (4) mit denen (6) des zweiten Substrats (2), derart, daß die Außenanschlußflächen (10) des ersten Substrats (4) mit den ausgesparten oder aussparbaren Bereichen (12; 40) des zweiten Substrats (2) ausgerichtet sind und durch das zweite Substrat (2) überdeckt sind;
Dünnen des zweiten Substrats (2); und
Freilegen der Außenanschlußflächen (10) durch die ausgesparten oder aussparbaren Bereiche zum Erzeugen der externen Anschlüsse beim Dünnen des zweiten Substrats (2) oder nach dem Dünnen des zweiten Substrats (2).

2. Verfahren nach Anspruch 1, bei dem das erste und das zweite Substrat (4, 2) derart verbunden werden, daß die Anschlußflächen (8, 6) auf dem ersten und dem zweiten Substrat ausgerichtet zueinander sind.

3. Verfahren nach Anspruch 1 oder 2, bei dem in dem zweiten Substrat (2) ausgesparte Bereiche (12; 40) vorgesehen sind, so daß nach dem Dünnen des zweiten Substrats (2) die Außenanschlußflächen (10) durch das zweite Substrat (2) zugänglich sind.

4. Verfahren nach Anspruch 1 oder 2, bei dem in dem zweiten Substrat (2) aussparbare Bereiche (12; 40) vorgesehen sind, wobei nach dem Dünnen des zweiten Substrats (2) die aussparbaren Bereiche ausgespart werden, so daß die Außenanschlußflächen (10) durch das zweite Substrat (2) zugänglich sind.

5. Verfahren nach einem der Ansprüche 1 bis 4, bei dem das Verbinden des ersten und des zweiten Substrats (4, 2) mittels eines Klebers (22) erfolgt, wobei die Außenanschlußflächen (10) bedeckende Teile des Klebers (22) durch die ausgesparten Bereiche (12; 40) des zweiten Substrats (2) beseitigt werden.

6. Verfahren nach einem der Ansprüche 1 bis 5, bei dem das zweite Substrat (2) von der zweiten, der ersten Hauptoberfläche gegenüberliegenden Hauptoberfläche desselben her gedünnt wird, derart, daß die ausgesparten oder aussparbaren Bereiche (12; 40) das zweite Substrat (2) vollständig durchdringen.

7. Verfahren nach einem der Ansprüche 1 bis 6, bei dem das erste und das zweite Substrat ein erster und ein zweiter Wafer (4, 2) sind, die jeweils eine Mehrzahl integrierter Schaltungen in der ersten Hauptoberfläche derselben mit jeweils zugeordneten Anschlußflächen (6, 8) auf der ersten Hauptoberfläche derselben aufweisen.

8. Verfahren nach Anspruch 7, bei dem der zweite Wafer (2) ausgesparte oder aussparbare Trennungsfugen (14) aufweist, die Positionen für Sägestraßen für eine Vereinzelung der jeweils verbundenen integrierten Schaltungen in dem ersten und dem zweiten Wafer (4, 2) definieren.

9. Verfahren nach Anspruch 8, bei dem die Trennungsfugen (14) den zweiten Wafer (2) nach einem Dünnen desselben vollständig durchdringen.

10. Verfahren zur Herstellung von Mehrchipmodulen mit folgenden Schritten:
Durchführen des Verfahrens nach einem der Ansprüche 7 bis 9; und
Vereinzeln der Mehrschichtstruktur zu einer Mehrzahl von Mehrchipmodulen.

## Claims

1. Method for vertically integrating active circuit layers for producing a multi-layer module, wherein integrated circuits are connected, via internal pads, so as to be electrically conductive, the multi-layer module comprising external terminals, the method comprising:
providing a first substrate (4) with at least one integrated circuit in a first main surface of said substrate, and with internal pads (8) for the integrated circuit and with external pads (10) on the first main surface of said substrate;
providing a second substrate (2) with at least one integrated circuit in a first main surface of said substrate, with internal pads (6) for the integrated circuit and with recessed or recessable areas (12; 40) in the first main surface of said substrate (2);
mechanically connecting the first main surfaces of the first and second substrates (4, 2) and, thereby, simultaneously connecting the internal pads (8) of the first substrate (4) to those (6) of the second substrate (2) so as to be electrically conductive, such that the external pads (10) of the first substrate (4) are aligned with the recessed or recessable areas (12; 40) of the second substrate (2) and are covered by the second substrate (2);
thinning the second substrate (2); and
exposing the external pads (10) through the recessed or recessable areas for producing the external terminals when thinning the second substrate (2) or after thinning the second substrate (2).

2. Method as claimed in claim 1, wherein the first and second substrates (4, 2) are connected such that the pads (8, 6) on the first and second substrates are aligned towards one another.

3. Method as claimed in claim 1 or 2, wherein recessed areas (12; 40) are provided in the second substrate (2), so that after thinning the second substrate (2), the external pads (10) are accessible through the second substrate (2).

4. Method as claimed in claim 1 or 2, wherein recessable areas (12; 40) are provided in the second substrate (2), the recessable areas being recessed after the second substrate (2) has been thinned, so that the external pads (10) are accessible through the second substrate (2).

5. Method as claimed in any one of claims 1 to 4, wherein the connecting of the first and second substrates (4, 2) is effected by means of an adhesive (22), wherein such parts of the adhesive (22) which cover the external pads (10) are removed through the recessed areas (12; 40) of the second substrate (2).

6. Method as claimed in any one of claims 1 to 5, wherein the second substrate (2) is thinned starting from the second main surface opposing the first main surface of said substrate, such that the recessed or recessable areas (12; 40) fully penetrate the second substrate (2).

7. Method as claimed in any one of claims 1 to 6, wherein the first and second substrates are first and second wafers (4, 2), each comprising a plurality of integrated circuits in the first main surface of said substrates each having associated pads (6, 8) on the first main surface of said substrates.

8. Method as claimed in any one of claims 1 to 7, wherein the second wafer (2) comprises recessed or recessable separating seams (14) defining positions for sawing lines for dicing the integrated circuits in the first and second wafers (4, 2), the integrated circuits being connected in each case.

9. Method as claimed in claim 8, wherein the separating seams (14) fully penetrate the second wafer (2) after same has been thinned.

10. Method for producing multi-chip modules, comprising:
carrying out the method as claimed in any one of claims 7 to 9; and
dicing the multi-layer structure to form a plurality of multi-chip modules.

## Revendications

1. Procédé pour l'intégration verticale de plans de circuit actifs destinés à générer un module à couches multiples dans lequel les circuits intégrés sont reliés de manière électroconductrice par des faces de connexion intérieures et présentant des connexions extérieures, aux étapes suivantes consistant à :
préparer un premier substrat (4) avec au moins un circuit intégré dans une première surface principale de celui-ci et avec des faces de connexion intérieures (8) du circuit intégré et avec des faces de connexion extérieures (10) sur sa première surface principale ;
préparer un second substrat (2) avec au moins un circuit intégré dans une première surface principale de celui-ci, avec des faces de connexion intérieures (6) du circuit intégré et avec des zones évidées ou pouvant être évidées (12 ; 40) dans sa première surface principale ;
assembler mécaniquement les premières surfaces principales du premier et du second substrat (4, 2) et, de ce fait, à assembler simultanément de manière électroconductrice les faces de connexion intérieures (8) du premier substrat (4) avec celles (6) du second substrat (2), de sorte que les faces de connexion extérieures (10) du premier substrat (4) soient alignées sur les zones évidées ou pouvant être évidées (12; 40) du second substrat (2) et soient recouvertes par le second substrat (2);
amincir le second substrat (2) ; et
dégager les faces de connexion extérieures (10) à travers les zones évidées ou pouvant être évidées, pour générer les connexions extérieures lors de l'amincissement du second substrat (2) ou après l'amincissement du second substrat (2).

2. Procédé selon la revendication 1, dans lequel le premier et le second substrat (4, 2) sont assemblés de telle sorte que les faces de raccordement (8, 6) sur le premier et le second substrat soient alignées l'une sur l'autre.

3. Procédé selon la revendication 1 ou 2, dans lequel il est prévu, dans le second substrat (2), des zones évidées (12 ; 40), de sorte que, après l'amincissement du second substrat (2), les faces de connexion extérieures (10) soient accessibles à travers le second substrat (2).

4. Procédé selon la revendication 1 ou 2, dans lequel il est prévu, dans le second substrat (2), des zones pouvant être évidées (12 ; 40), les zones pouvant être évidées étant évidées après l'amincissement du second substrat (2), de sorte que les faces de connexion extérieures (10) soient accessibles à travers le second substrat (2).

5. Procédé selon l'une des revendications 1 à 4, dans lequel l'assemblage du premier et du second substrat (4, 2) s'effectue à l'aide d'un adhésif (22), les parties de l'adhésif (22) recouvrant les faces de connexion extérieures (10) étant éliminées à travers les zones évidées (12 ; 40) du second substrat (2).

6. Procédé selon l'une des revendications 1 à 5, dans lequel le second substrat (2) est aminci depuis sa seconde surface principale, opposée à la première surface principale, de sorte que les zones évidées ou pouvant être évidées (12 ; 40) traversent entièrement le second substrat (2).

7. Procédé selon l'une des revendications 1 à 6, dans lequel le premier et le second substrat sont une première et une seconde plaquette (4, 2) présentant, chacune, une pluralité de circuits intégrés dans leur première surface principale avec des faces de connexion (6, 8) associées respectives sur leur première surface principale.

8. Procédé selon la revendication 7, dans lequel la seconde plaquette (2) présente des joints de séparation (14) évidés ou pouvant être évidés, lesquels définissent les positions des chemins de sciage pour une séparation des circuits intégrés reliés respectifs dans la première et dans la seconde plaquette (4, 2).

9. Procédé selon la revendication 8, dans lequel les joints de séparation (14) traversent entièrement la seconde plaquette (2) après un amincissement de celle-ci.

10. Procédé de réalisation de modules à plusieurs puces, aux étapes suivantes consistant à :
mettre en oeuvre le procédé selon l'une des revendications 7 à 9 ; et
séparer la structure à couches multiples, pour former une pluralité de modules à plusieurs puces.
